# EUROPEAN PATENT APPLICATION

(11) **EP 2 325 613 A1**
(43) Date of publication of application: **25.05.2011**
(21) Application number: 09382248.4
(22) Date of filing: 16.11.2009
(51) Int. Cl.: G01D 21/00

(54) **Microelectromechanical sensing device**

(71) Applicant: Farsens, S.L., 20006 Donostia - SanSebastian, Guipuzcoa (ES)
(72) Inventor: Sevillano Berasategui, Juan Francisco, E-20009 San Sebastian (Guipúzcoa) (ES); Asensio Cermeño, Alejandro, E-20009 San Sebastian (Guipúzcoa) (ES); García-Alonso Montoya, Andrés, E-20009 San Sebastian (Guipúzcoa) (ES); Puente Urruzmendi, Iñigo, E-20009 San Sebastian (Guipúzcoa) (ES); Rebollo Pimentel, Iván, E-20009 San Sebastian (Guipúzcoa) (ES); Pardo Sánchez, Daniel, E-20009 San Sebastian (Guipúzcoa) (ES)
(74) Representative: ABG Patentes, S.L.

(57) **Abstract**

The present invention is aimed at an analog output microelectromechanical (MEMS) sensing device internally comprising a transducer in which first and second senstivie reading elements of a physical magnitude with different absolute value of their respective sensitivity are located in different sites. This allows reducing energy consumption when it is used with circuits which make use of the signal provided by said sensor, the reduction of manufacturing costs and the combination between integrated circuit manufacturing techniques, such as CMOS (Complementary Metal Oxide Semiconductor) and MEMS (Micro-Electro-Mechanical Systems) for example. The multiple signal output may facilitate digitalization of the measurement and give rise to a device requiring a smaller area given that the associated circuits are simplified. The same device may have other technical advantages by means of uses suited for the circuits to which it is connected.

## Description

### Object of the Invention

The present invention is aimed at a microelectromechanical sensing device which allows reducing consumption when it is used with circuits which make use of the signal provided by said sensor. The same invention likewise entails other technical advantages that are no less important, such as the reduction of manufacturing costs and allowing the combination between integrated circuit manufacturing techniques, such as CMOS (Complementary Metal Oxide Semiconductor) and MEMS (Micro-Electro-Mechanical Systems) for example.

Mechanical sensors, and particularly microelectromechanical sensors, are based on the shift or deformation caused in a mechanical transduction element caused by the magnitude to be measured. This mechanical transduction element can be a membrane, a beam, etc., which experiences deformation when it receives external stressing that can be translated into a measurable output signal: for example a difference of potential (hereinafter referred to simply as potential). Examples of sensors are piezoresistive or capacitive sensors.

The present invention achieves this objective by making use of a suitable combination of sensitive reading elements on one and the same transducer component such that the multiple signal output facilitates digitalization of the measurement and gives rise to a device requiring lower energy consumption and a smaller area given that the associated circuits are simplified. The same device has other technical advantages by means of uses suited for the circuits to which it is connected.

### Background of the Invention

The main technical problem that the invention deals with is the reduction of components and consumption in devices which make use of sensors manufactured by means of MEMS technology.

The reduction of consumption is essential for applications such as wireless applications: whether it is to increase the duration of the batteries, or to make it possible for wireless sensors to operate battery-free (powered by means of other techniques).

The reduction of consumption in battery-powered wireless sensors allows increasing the service life without maintenance and it prevents ecological recycling problems with batteries. If the battery is furthermore eliminated, maintenance and recycling of the sensor become unnecessary.

In the case of wireless sensors powered by radio frequency using RFID (Radio Frequency Identification) technology to communicate, the demands of low consumption are especially critical in order to be able to power the sensor and the circuits associated with said sensor. A reduction in the consumption of the sensor directly affects the viability of battery-free RFID sensors.

The consumption of a digital sensor is the sum of the consumption of the sensor itself plus the consumption of the converter providing the digital output, the consumption of the converter being able to be greater than the consumption of the sensor itself.

The analog signal of the sensor is a function of the measurement of a variable evaluated in the transducer such as the resistance or capacitance. There are several methods for converting to a digital signal, among which the following are mentioned:
- *Successive approximation:* This is the most commonly used method, suitable for applications that do not need large resolutions or high speeds. Due to its low cost, it is usually integrated in most microcontrollers allowing, as mentioned, a low-cost solution in a single chip for a number of control applications. The converter performs a dichotomic search of the value present at the input. Its main limitation is the large conversion time necessary.
- *Flash:* this converter stands out due to its high operating speed. It is formed by a chain of voltage dividers and comparators, performing the conversion immediately in a single operation. Its main drawback is the high cost.
- *Sigma-delta:* They have a low maximum conversion rate but in contrast they have a very high signal to noise ratio, the highest of all.

If for example a flash converter is considered, the chain of voltage dividers used to have different reference levels of potential which allow quantifying the signal and the comparators lead to a consumption of space and electric current which can be avoided with the present invention.

The same occurs if the reading of the additional sensitive element is to be used for correcting; for example, to achieve the linearization of the response or modification of the offset.

Configurations are known, such as the Wheatstone bridge, in which two sensitive reading elements are suitably concatenated to duplicate sensitivity by making use of two areas of maximum sensitivity and opposite sign (for example an element subjected to tension and another one to compression), and adding the signals obtained by both sensitive elements. The objective is only to obtain the same signal with a higher intensity or value.

Nevertheless, the use of sensitive reading elements arranged in areas of the transducer which lead to fractions of the maximum signal or which are different such that they serve to form circuits which require fewer components for their operation without making use of an additional area in their manufacture is not considered in such configuration.

The present invention solves these problems by means of a device which offers more than one output signal with degrees of sensitivity differing in absolute value which allow using the area occupied by the MEMS, favoring the reduction of the area used as well as of the consumption of the end device.

Additional technical advantages which are obtained with the invention will be described in detail in the description of the invention.

### Description of the Invention

The present invention consists of a microelectromechanical sensing device. The microelectromechanical sensors of the state of the art incorporate a transducer which is able to deform due to external stressing. For example, a fixed-end beam with an inertial mass in its central part will bend depending on the acceleration; or a membrane can deform depending on the pressure differences that is established on both sides of its surface.

This transducer element has what will be referred to hereinafter as a sensitive reading element which allows transforming a physical magnitude, such as the acceleration, the pressure or a force into a signal. This signal can be a potential or a current. The sensitive reading element differs from the sensor because according to the invention, the latter can have several sensitive reading elements. Therefore, the sensitive reading element is the basic component which allows the reading of the deformation or shift of the transducer at a certain point thereof, hence one and the same transducer can contain more than one sensitive reading element.

The sensitive reading elements can be piezoresistive or capacitive elements for example.

The transducers formed from deformable or shiftable elements frequently have several areas with a gradation of different shifts or deformations. For example, a membrane which shifts with the pressure shifts maximally in the center and does not shift at all in the edges in which it is fixed; and in terms of deformations, it does not deform at all in the center or in the edges, having a gradation of tensions and compressions in the rest of the area. Something similar occurs in cantilever beams which are used to support an inertial mass to obtain an acceleration sensor. There will generally be a maximum point of deformation or shift, a minimum point and all the intermediate values will also exist given that they are variables which show continuous variation.

In the state of the art, sensitive reading elements are located at the points where the deformation or shift are maximum in order to have a device with maximum sensitivity.

The sensitivity S will be defined as the value of variation of the Y signal of a sensitive reading element with respect to a physical magnitude X:

*s*=∂Y/∂X.

In addition to the present invention internally comprising a transducer in which there is a first sensitive reading element of a physical magnitude, the same transducer comprises at least a second sensitive reading element located in a different place with respect to the first element, and in which this second sensitive reading element has a sensitivity differing in absolute value from the sensitivity of the first sensitive reading element.

The present invention takes advantage of the gradualness or continuous variation of the response in the transducer depending on the position and on the size of the sensitive reading element.

In practice, the invention also takes advantage of the regularity and perfection of monocrystalline silicon which is used in devices obtained by micromachining techniques, as well as of the precision of lithography techniques which allow placing a deformation-sensitive element (for example a piezoresistor) at a point characterized by having, for example, a known fraction of the maximum deformation. In other words: there is always a point of the transducer with the desired fraction of the maximum deformation of the same transducer.

There is hardly any dispersion in the position of this point; a sensitive reading element can be very precisely positioned at the desired point. Using again as an example the place in which the deformation is maximum as the place of reference, the position in which a desired fraction of said maximum deformation occurs can be mechanically calculated with extreme precision. Furthermore, the mechanical precision improves over time due to the evolution of the applied techniques.

There are several applications which allow including this second sensitive reading element with different sensitivity, some of which will be described in detail in the section of the detailed description of the invention. Nevertheless, an important technical advantage can be indicated.

The use of areas in which the response is maximal means that the rest of the area in which the response is lower is not used. Nevertheless, the manufacturing cost is evaluated in terms of area and this unused area equally increases the cost. The incorporation of two or more sensors in areas of reduced sensitivity to the response does not increase the area of the sensor and it does increase the features and subsequent applications.

The problem of the fast increase of the cost with the area is aggravated when the sensitive elements obtained by micromachining technologies and the complementary electronic circuitry obtaining by integrated circuit manufacturing techniques are combined in a single chip. The correct operation of these circuits would be altered if they are located in deformable areas. To that end, in addition to the areas of reduced sensitivity being useless from the sensor point of view, they are useless from the circuitry point of view. However, the price per unit of area of manufacture of a circuit is considerably greater than the price corresponding to a micromachined area for example to obtain a sensor. Therefore, by making use of the invention, the final price of the product is reduced by eliminating area in the manufacture of the circuit by adding components in the sensor making use of an area that would otherwise not be used.

The technical problem consists of finding the way of taking advantage of the areas of reduced sensitivity for sensitive element functions, or for performing functions which are normally performed by the integrated circuits.

The different ways of configuring the sensor with analog outputs coming from sensitive reading elements of different sensitivity to one and the same external excitation resulting from the possible combinations given by dependent claims 2 to 10 are incorporated by reference to this description.

The device with digital output which results from combining a sensor and a circuit as is established in dependent claim 11 is incorporated by reference to this description.

RFID devices according to claim 12 are considered to be incorporated by reference to this description.

### Description of the Drawings

These and other features and advantages of the invention will become clearer from the following detailed description of a preferred embodiment, given only by way of a non-limiting illustrative example with reference to the attached drawings.
Figure 1 shows an example of a microelectromechanical device of the state of the art. The device is a single axis accelerometer based on a capacitive sensitive reading element.
Figure 2 shows the deformation of a central section of a membrane pointing out the different points of interest.
Figures 3a and Figure 3b show an embodiment of the invention based on a design such as that of Figure 1 in which a plurality of capacitive sensitive reading elements on the same transducer are now used.
Figure 4 shows a sensor incorporating a 3-bit flash circuit which allows converting the output of a sensor according to the state of the art into a digital output.
Figure 5 shows a sensor according to an embodiment of the invention with multiple outputs as well as the 3-bit flash-type associated circuit for converting the signals into a digital output. This diagram allows comparison with the previous figure of the state of the art.
Figures 6a and 6b show the ratios of area occupied by a sensor and the circuits with an integrated circuit manufacturing technology, such as CMOS from an example of the state of the art (Figure 6a) and from an embodiment of the invention (6b) for example.

### Detailed Description of the Invention

The present invention consists of a microelectromechanical sensing device which allows, by means of its use, reducing the number of components of the device which use it by reducing the manufacturing costs as well as the consumption of the latter.

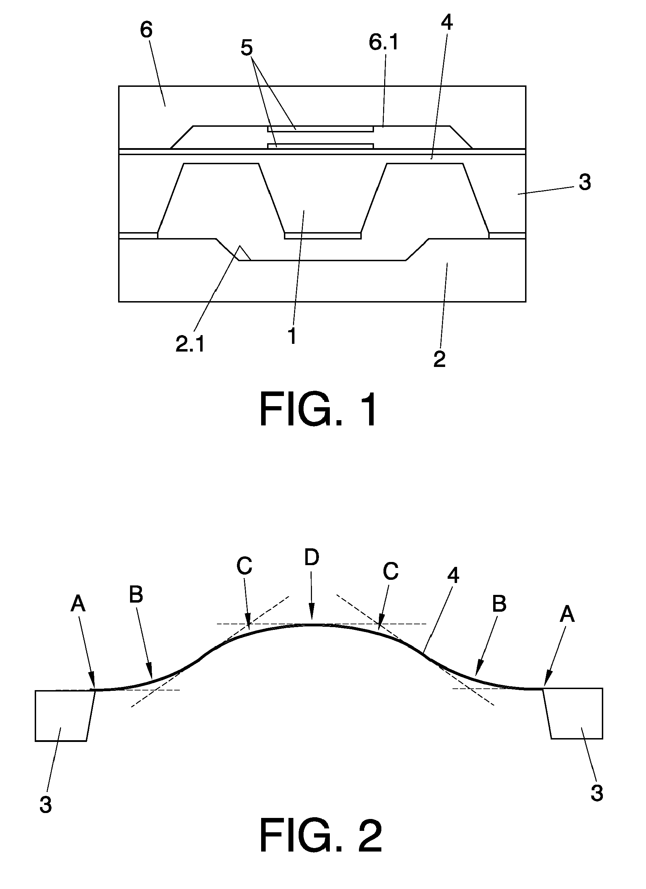

Figure 1 shows an example of a microelectromechanical device belonging to the state of the art which is formed by a substrate serving as a lower rigid support (2). Located on this lower rigid support (2) there is a suspended mass (1) that is suspended by means of sections linked to a side support (3) giving rise to the transducer (4). The suspended mass (1), which is part of the transducer (4), the transducer (4) and the side support (3) belong to one and the same original substrate which has been micromachined. Likewise, the lower rigid support (2) shows a micromachining in its upper part giving rise to a cavity (2.1) which allows the vertical oscillations of the suspended mass (1) when it is in operating mode without mechanical interferences occurring with the lower rigid support (2). The vertical oscillations occur due to accelerations which produce forces due to inertial effects in the suspended mass (1) and the latter (1) shifts due to the fact that the transducer (4) has arms or beams of reduced section and it bends due to stressing, the inertial forces, exerted on the suspended mass (1).

Located above the suspended mass (1) there is an upper rigid support (6) also formed by a micromachined substrate. This rigid support (6) also has a second cavity (6.1) housing two conducting plates (5). These conducting plates (5) are separated by a dielectric and form a capacitor. These plates (5) thus arranged result in this embodiment in what is referred to as a sensitive reading element.

The upper plate (5) is integral with the upper rigid support (6) and the lower plate (5) is integral with the suspended mass (1) such that the movement of the lower plate (5) is faithful to the movement of the suspended mass (1).

The variation of the separating distance between plates (5) due to the movements of the suspended mass (1) lead to variations of the capacitance and allow configuring a sensor for the measurement of the acceleration to which it is subjected.

As occurs in the state of the art, the position of the plates (5) of the capacitor is located in the central part in which the variations of the shift are constant and maximum, the surface of the beams not being occupied.

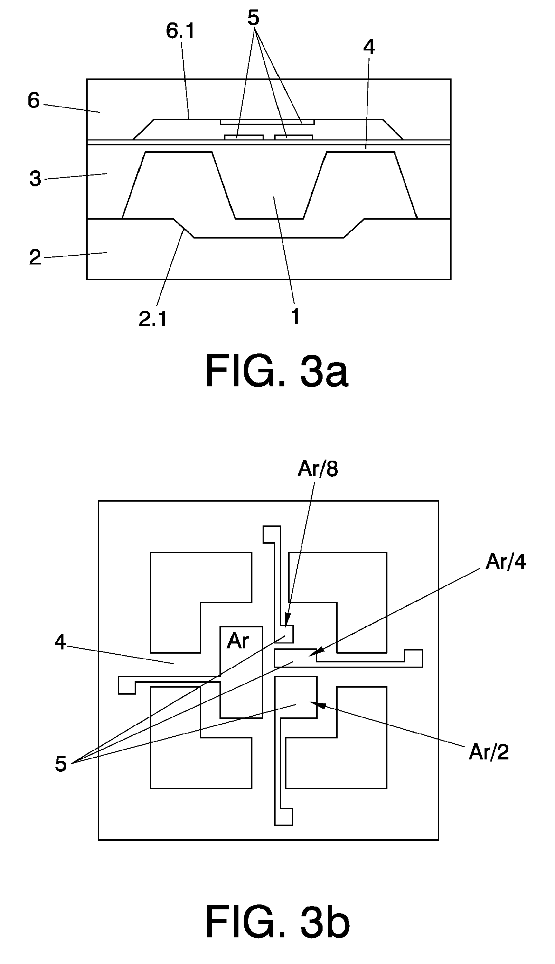

Figure 3 shows an embodiment of the invention in which a sensing device such as that of Figure 1 according to the state of the art has been modified by applying the solution proposed by an embodiment of the present invention to incorporate multiple sensitive reading elements formed by plates (5) distributed and configured in a particular manner.

A first pair of plates (5) has an area Ar. Each additional pair of plates (5) giving rise to a sensitive reading element has an area which is half the previous one, establishing in this example a sequence of pairs of plates (5) with areas Ar, Ar/2, Ar/4 and Ar/8.

The distribution of these plates (5) can be done without having to increase the area of the device thus formed because since the area of each additional sensitive reading element is divided by 2 it can be located in an area which otherwise would not have been used.

This technical advantage is observed to a greater degree in piezoresistive devices in which the sensitive reading element is arranged at a point along the length of the transducer (4). Arranging additional sensitive reading elements with lower sensitivities corresponding to fractions 1/2, 1/4, 1/8, also gives rise to elements located at points of the transducer which otherwise would not be used. Given that the total area of the sensing device has not been increased, nor are the manufacturing costs increased.

Another embodiment according to the invention, which is not depicted in the drawings, of a transducer (4) formed by a fixed-end beam incorporates sensitive reading elements at the site where they are fixed (in which deformation is maximum) and at least another sensitive reading element at a point between the fixing and the end, in which in the latter sensitivity to deformation is nil. This other sensitive reading element (or more) uses a region of the beam which otherwise would not be used.

The combination of different types of sensitive reading elements is also considered part of the invention, for example, by means of the combination of plates (5) forming a capacitor in the central part of the example shown in Figure 1 and of piezoresistive elements arranged in the arms of the element transducer (4). In this case, it is also possible to combine different types of readings.

The pressure sensors of the state of the art make use of a membrane to measure the pressure differences existing between its faces using only the areas of shift or maximum deformation. The present invention takes advantage of the fact that, depending on the location of the sensing element in the membrane, different readings would be obtained. The different positions of the sensing element would give rise to different sensitivities. The invention makes a combined use of these areas of less variation with those of greater variation used in the state of the art.

Figure 2 shows a section of a membrane fixed on its entire periphery and subjected to a pressure difference between its upper and lower faces. The membrane in this case is the transducer (4) and it experiences a deformation that has been exaggerated to indicate the different points of interest.

The letter A identifies the area of the fixing in which the shift is minimal. The letter D identifies the area of maximum shift. The letter B identifies the area of maximum deformation under compression, and the letter C identifies the area of maximum deformation under tension.

From the points in which the maximum of a variable is obtained and the points in which a minimum of the variable occurs, there is a continuous variation such that all the intermediate values are reached. In particular, it is possible to find exact fractions of the maximum value.

It is interesting to consider intermediate values which are divided by a power of 2. In other words, in which with a variable X, values X/2, X/4, X/8,... or also values equidistant to one another, are obtained.

The present invention uses these known fractions so that either directly or by means of comparison and/or sum and difference operations, a number which reflects the magnitude in the desired base can be obtained in a suitable manner. Likewise, if sensitive reading elements as well as other sensitive reading elements with reduced sensitivities X/2, X/4, X/8, X/16 are located at the point of maximum deformation X, mechanically processed information is available such that it allows easily obtaining digital or binary output with circuits which require less area, use fewer components and furthermore have lower consumption. Likewise, if the points of deformation X/10, X/100... were used, a decimal output would easily be obtained.

The transition of this multiple analog signal to digital requires subsequent circuits with a lower energy consumption. Examples of these circuits will be described in detail below and are also part of the invention.

Having seen these examples of sensors according to embodiments of the invention, devices making use of such sensors to obtain digital readings and to thus show how the consumption and the components necessary for carrying out the objective of the circuits coupled to the sensors are reduced are described. Therefore the digital output devices obtained by making use of sensors with multiple sensitive reading elements incorporated in one and the same transducer (4) are also object of this invention.

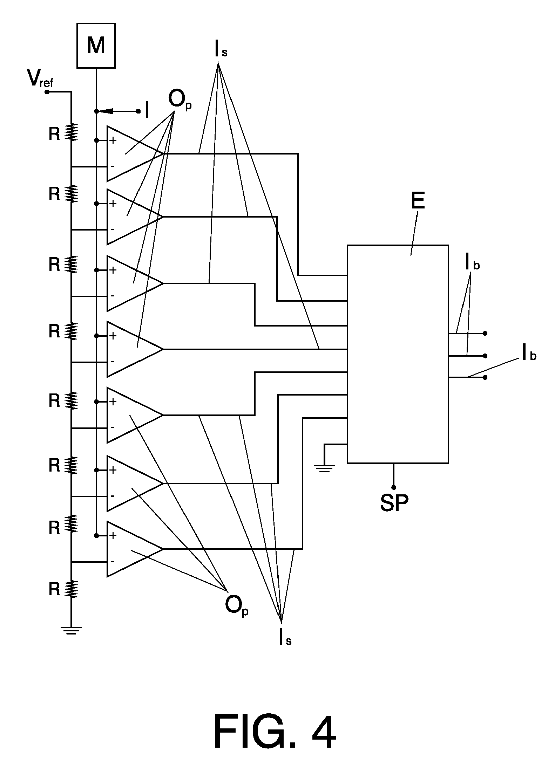

Figure 4 shows a flash circuit associated with a sensor (M) such as the one from the state of the art, in which the flash circuit allows a 3-bit digital output.

In this example of a circuit from the state of the art the sensor (M) provides an analog signal (I). This analog signal is compared with a plurality of reference values which come from a voltage divider established by an assembly of resistors (R) arranged in series and polarized with a potential Vref.

If all the resistors are identical, the same signal (I) is compared with fractions of Vref, i.e., in this case it is compared with Vref/8, 2Vref/8, 3Vref/8, 4Vref/8,...

The signal (I) is compared by means of comparators (Op) with this collection of reference values such that the output will be 1 if the value of the signal exceeds its reference value and 0 in any other case. In this embodiment, the comparators (Op) are operational amplifiers.

Of the eight output lines (lₛ) of the comparators (Op), those for which the value of the signal (I) is less than its reference value will be 0 and the rest of the lines (lₛ) will be 1. Depending on the level of the signal (I), the jump from 0 to 1 will occur in the line which corresponds to the closest reference value. The representation of the value of the quantized signal (I) in the eight possible situations of the lines is binary-encoded by the encoder (E) which in this case only needs 3 bits to represent the 8 values. The output is carried out by the binary output (l_{b}).

The encoding is carried out when encoder (E) receives the instruction through the input (sp) (sampling pulses).

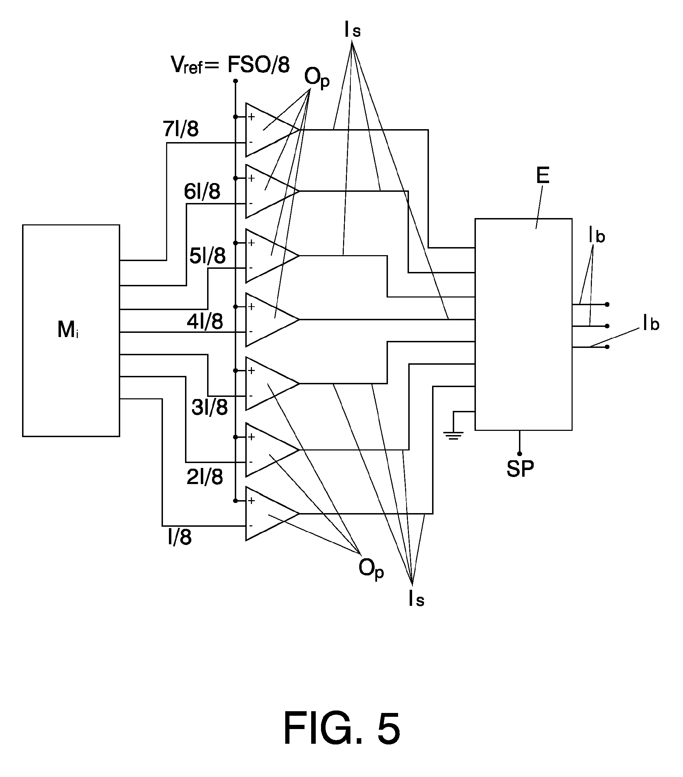

Figure 5 shows a circuit like that of Figure 4 but adapted to give rise to an embodiment of the invention. In this new scheme, use is made of a sensor (Mi) with a circuit for the digital output in which the sensor (Mi) comprises seven sensitive reading elements according to an embodiment of the invention. This sensor (Mi) has seven analog outputs in which, for one and the same external stressing, they deliver a value of the signal 1/8, 21/8, 31/8, 41/8, 51/8, 61/8 and 71/8 simultaneously. In other words, the values of the signal are reduced such that the sensitivities are equally distributed between the maximum 71/8 and the minimum 1/8. In this example there is no output of maximum sensitivity which delivers a signal of value I.

Instead of having a voltage divider which consumes energy to deliver a set of reference values, the seven signals of the sensor (Mi) are compared with a single reference value Vref which in this embodiment corresponds to the maximum value of the measurement range of the signal divided by 8.

If the stressing received in the sensor (Mi) is maximal, even the output delivering 1/8 exceeds the reference value so all the comparators (Op) deliver 1. For intermediate values, in a manner proportional to the signal, a set of comparators (Op) will be 1 but after one of them, the value will be 0. A quantized representation of the reading is thus obtained as it was obtained in the output lines (lₛ) in the previous case, but the components of the voltage divider and also the consumption associated therewith disappear. The rest of the components and their operation until reaching the digital output of the measurement are the same. The overall consumption of the sensing device with digital output is lower.

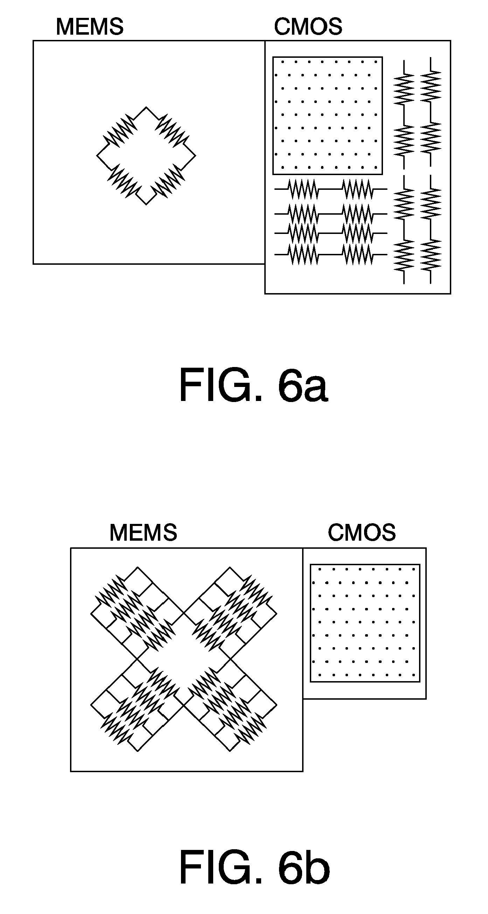

Figure 6a shows a device according to the state of the art in which the area occupied by four microelectromechanical sensors located on the left and the area of the circuit with an integrated circuit manufacturing technology, such as for example CMOS, on the right are observed. Some passive components which occupy a large area, such as for example the resistors that are used to create the references in analog-digital converters, have been highlighted in the area of the circuit.

In Figure 6b, according to an embodiment of the invention, the sensor is modified, incorporating more sensitive reading elements in each transducer (4) such that the associated circuit with an integrated circuit manufacturing technology, such as for example CMOS, depicted on the right, requires fewer components and lower consumption.

In view of the examples of how to carry out the invention, particularly in those intended for digital output which assesses the excitation received by the sensor, it can be established therein to carry out a method according to claim 13, 14 or 15 in which such claims are incorporated by reference to this description.

When the present invention is applied to the digitalization process, instead of establishing comparisons of a signal obtained in a sensing element with several references as occurs in the state of the art, the present invention establishes a method which compares a suitably chosen single reference with fractioned values of the same signal. In the case of using a flash configuration, the comparisons are carried out at the same time.

In both cases, on a set of sensitivities Sᵢ ordered by their value, which in any case can be identified as S₀S₁, S₂,...,Sₙ, with S₁ S₂,...,Sₙ smaller fractions of S₀, what is sought is the transition from Sᵢ to Sᵢ₋₁ in which the condition that the value of the signal Vref is in the interval [Sᵢ, Sᵢ₋₁] is met. Having chosen a decreasing order for the indices does not eliminate any generality of the method since in another case, the outputs of the sensor would be ordered in another way by only changing the index which identifies each output. By establishing the interval [Sᵢ, Sᵢ₋₁] in which the reference value Vref is located, values 0 are established for the indices i associated with one side of the interval and 1 for the rest of the indices, giving rise to a binary representation which can be transformed (in terms of its format) by an encoder (E).

## Claims

1. An analog output microelectromechanical sensing device internally comprising a transducer (4) in which a first sensitive reading element of a physical magnitude is located, **characterized in that** the same transducer (4) comprises at least a second sensitive reading element located in a site different from the first one and in which this second sensitive reading element has a sensitivity differing in absolute value from the sensitivity of the first sensitive reading element.

2. A device according to claim 1, **characterized in that** the first sensitive reading element is located in the transducer (4) in the area of greatest sensitivity of the transducer (4) and the second sensitive element is located in the same transducer (4) in an area of reduced sensitivity.

3. A device according to claim 1 or 2, **characterized in that** it has several sensitive reading elements located in the same transducer (4) in an area of reduced sensitivity.

4. A device according to claim 3, **characterized in that** it has a selector that determines which sensitive reading element or elements are active.

5. A device according to any of claims 1 to 4, **characterized in that** different sensitive reading elements located in one and the same transducer (4) use two or more different transduction principles.

6. A device according to claim 5, **characterized in that** the sensitive reading elements existing in one and the same transducer (4) are capacitive transducers and piezoresistive transducers.

7. A device according to any of claims 1 to 5, **characterized in that** in addition to the first sensitive reading element with sensitivity S₀, it has *n* sensitive reading elements, with sensitivities Sᵢ (i=1,...,n) such that Sᵢ =Sᵢ₊₁*b* in which *b* is a scaling factor is verified.

8. A device according to claim 7, **characterized in that** the parameter *b* is 2, giving rise to a sequence of sensitivities S₀, S₁₌S₀/2, S₂₌S₀/4,.., Sₙ=S₀/2ⁿ.

9. A device according to any of claims 1 to 5, **characterized in that** in addition to the first sensitive reading element with sensitivity S₀, it has *n* sensitive reading elements, with different sensitivities Sᵢ (i=1,...,*n*) such that Sᵢ-Sᵢ₋₁ is equal to a determined constant for all i=1,...*n*.

10. A device according to claim 9, **characterized in that** once the value So is determined, the sensitivities Sᵢ have a value of the form i*S₀/(n+1) for i=1,...,*n*.

11. A digital output sensing device **characterized in that** it comprises:
• an analog output device (Mi) according to any of claims 1 to 10 having n outputs with different sensitivity,
• a connection for the input of a reference value (Vref),
• an encoder (E),
• *n* comparators (Op) in which each of them has an input connected to a sensitive reading element different from the analog output device (Mi) and the other input of the comparator (Op) is connected to the connection for the input of the reference value (Vref); and the output (lₛ) of the comparator (Op) is connected to the input of the encoder (E) such that the output lines (lₛ) of the comparators entering the encoder (E) are ordered according to the sensitivity of the sensitive reading element from which the comparator (Op) originates,
wherein the output of the encoder (E) is the output (l_{b}) in digital representation of the stressing acting on the sensing device.

12. An RFID device **characterized in that** it incorporates a device according to any of the previous claims.

13. A method for establishing an interval which limits the value of the analog signal obtained by means of a sensor according to claim 3 due to an external excitation, which sensor comprises a sensitive reading element of sensitivity So and n sensitive reading elements of sensitivities Sᵢ such that, due to an external excitation, they reproduce the signal So according to smaller fractions and wherein S₁ S₂,...,Sₙ are the sensitivities Sᵢ ordered by their value, **characterized in that** it comprises the following steps:
a) providing a reference value (Vref) less than S₀,
b) determining, by applying comparisons on the sensitive reading elements, two sensitive reading elements in consecutive order of value of sensitivity Sᵢ, Sᵢ₋₁ such that Vref is in the interval [Sᵢ, Sᵢ₋₁]
wherein [Sᵢ, Sᵢ₋₁] is the interval which limits the value of the analog signal obtained by means of the sensor.

14. A method according to claim 13, wherein the values of sensitivity S₀, S₁, S₂,...,Sₙ are equidistant to one another.

15. A method according to claim 13 or 14, wherein once the interval [Sᵢ, Sᵢ₋₁] in which the reference value Vref is located is identified, values 0 are established for the indices i associated with one side of the interval and 1 for the rest of the indices, giving rise to a binary representation which can be transformed, in terms of its format, by an encoder.
